Europäisches Patentamt

**European Patent Office**

**Office européen des brevets**

(19)

(11) Publication number: **0 071 335**
**B1**

(12) # EUROPEAN PATENT SPECIFICATION

(45) Date of publication of patent specification: **15.10.86**

(51) Int. Cl.[4]: **H 01 L 29/78, H 01 L 29/08**

(21) Application number: **82302993.9**

(22) Date of filing: **10.06.82**

(54) Field effect transistor.

(30) Priority: **27.07.81 US 286927**

(43) Date of publication of application:
**09.02.83 Bulletin 83/06**

(45) Publication of the grant of the patent:
**15.10.86 Bulletin 86/42**

(84) Designated Contracting States:
**DE FR**

(56) References cited:
**EP-A-0 015 675**
**DE-B-2 636 350**
**US-A-3 959 025**
**US-A-4 011 576**

**IEEE TRANSACTIONS ON ELECTRON
DEVICES, vol. ED-27, no. 8, August 1980, pages
1352-1358, IEEE, New York, USA K. OHTA et
al.: "Quadruply self-aligned MOS (QSA MOS) -
A new short-channel high-speed hight-density
MOSFET for VLSI"**

(73) Proprietor: **XEROX CORPORATION**
**Xerox Square - 020**
**Rochester New York 14644 (US)**

(72) Inventor: **Haskell, Jacob D.**
**1301 Forrest Avenue**
**Palo Alto California 94301 (US)**

(74) Representative: **Weatherald, Keith Baynes et al**
**European Patent Attorney Rank Xerox Limited
Patent Department 338 Euston Road
London NW1 3BH (GB)**

Courier Press, Leamington Spa, England.

## Description

This invention relates to a short channel field effect transistor having a control plug positioned between the source and drain regions for eliminating the deleterious effects of substrate punch-through currents, without excessive junction capacitance.

The desire to achieve very large scale integrated (VLSI) circuits including upwards of 100,000 metal oxide semiconductor field effect transistors (MOSFET) and other logic devices on a single small silicon area ("chip") has led to an unrelenting search for approaches to diminish device size. As improvements are made, it will be possible to fabricate larger, self-contained, electronic systems on a chip which will have greater electronic switching capacity, will cost less per function, will be capable of performing more and more complex functions, will use less power and will be able to perform these functions in a shorter time. It had been thought at one time that it would be necessary only to reduce all the device dimensions and voltage levels proportionally and to modify doping levels appropriately. Initially, this approach was satisfactory. However, as will become apparent, the mere scaling down of all the elemental dimensions of the device, in and of itself, quickly leads to problems which detract from the performance of the logic devices and may even prevent their operation.

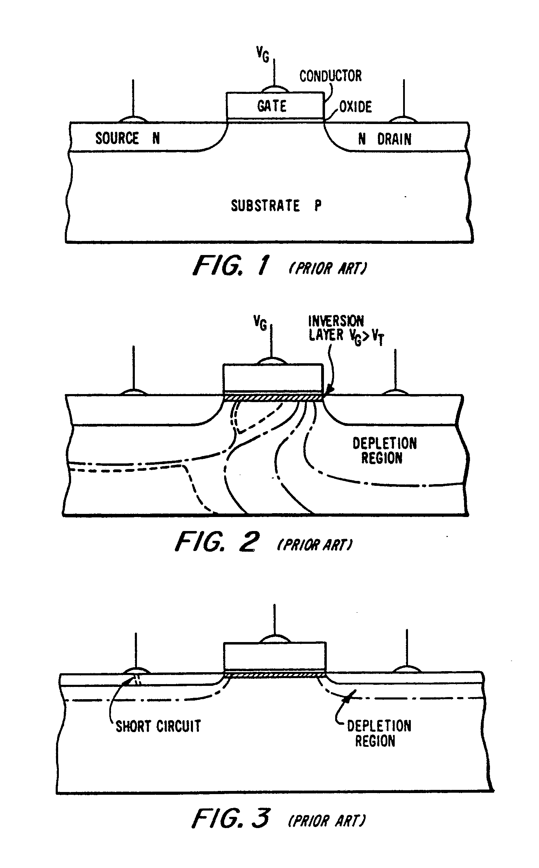

In the conventional MOSFET device illustrated in Figure 1 of the accompanying drawings there is provided a monocrystalline, or lightly-doped, semiconductor supporting substrate, of high bulk resistivity, of either the p or n conductivity type. Two spaced heavily-doped, low resistivity regions (source and drain) of the conductivity type opposite to the substrate bulk, are formed within the substrate by selective diffusion of appropriate dopants. Typically, the distance separating these two diffused regions is on the order of 1 μm. A thin conductive layer (the gate), of polysilicon or suitable metal, such as aluminum, overlies the area between the source and drain regions but is electrically insulated from them and the substrate by a thin dielectric layer of silicon dioxide. When a dielectric material other than silicon dioxide is used, the device may be termed a MISFET. Throughout this document, whenever the term MOSFET is used, it is contemplated that the term MISFET shall be equivalent, unless stated otherwise. The single device is connected to other devices in the circuit by ohmic contacts, usually of metal, connected to the low resistivity source and drain regions. It is made operative by connecting appropriate potential sources to the source, gate and drain, relative to the substrate.

The gate serves as the control element of the device. No transverse current will flow through the structure between the source and the drain junctions when the gate voltage is below threshold. However, optimally, when the desired gate-to-source switching voltage (gate threshold voltage) is applied to the gate, an inversion layer of opposite conductivity type will be induced in the substrate directly below the gate, providing a conductive path or channel, between the source and drain regions (as represented by cross-hatching in Figure 2 and the subsequent drawings, for ease of identification). This normally "OFF" type of operation, wherein the current carrying surface channel is formed by application of a voltage to the gate, is referred to as the "enhancement" mode.

When the device is normally "ON", and a conductivity channel is formed through the substrate between the source and drain regions at zero gate voltage, and application of a gate-to-source voltage of appropriate magnitude and polarity decreases the concentration of charge carriers in the channel to pinch-off current flow, the type of operation is referred to as the "depletion" mode.

The beneficial results attainable by decreasing the device size through a shorter channel length between source and drain have been accompanied by problems. A major performance limitation encountered, as the channel length is decreased, is punch-through. This phenomenon subverts the beneficial operation of the device by substantially decreasing, and in some cases eliminating, the control function performed by the gate. Punch-through occurs as a depletion region widens around the drain, in all directions, under the influence of the increasing drain voltages (as represented by the family of phantom lines in Figure 2), into the relatively lightly doped substrate bulk. When the drain voltage is sufficiently high, the growing drain depletion region overlaps with the depletion region around the source (as shown by the dotted lines in Figure 2) and charge carriers can be injected directly from the source into the drain depletion region where they are then swept by the electric field over to the drain.

In order to diminish depletion regions and minimize punch-through in short channel devices, the channel substrate region conductivity is increased. However, while decreasing the depletion region, the heavy doping (which extends to the junction depths) also increases the junction capacitance, thus slowing down the switching speed of the device. Thus, good device design usually dictates the proper balancing of doping levels and locations to minimize the depletion region and the junction capacitance while allowing a minimum length for the channel.

Another known approach to diminish the deleterious effect of the depletion region is illustrated in Figure 3 wherein the source and drain regions are formed as extremely shallow diffusions within the substrate. By so doing, while the depletion region will grow as just described, the growth will extend primarily beneath the source and drain junctions into the substrate bulk and not between these junctions. Punch-through will not take place. This device construction, while succeeding in its primary purpose, causes another problem to arise, namely, it is difficult to make a good ohmic contact with the extremely shallow junctions without the occurrence of a spike or short circuit directly from the electrode to the substrate.

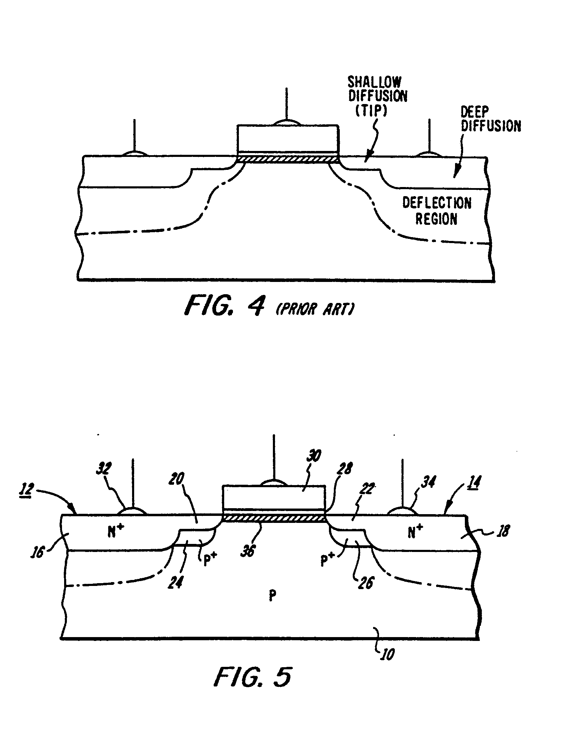

A prior approach which has been generally successful in diminishing the punch-through and junction capacitance is shown in Figure 4 and is disclosed in US—A—4,011,576. The MOSFET device shown is configured with source and drain junctions each formed with a heavily-doped shallow diffusion portion (the tip), between which there is a relatively short channel, and a lightly-doped deep diffusion portion. The spacing between the deep diffusion portions is made large enough so that even as the depletion region may become large, punch-through will be avoided. Similarly, the MISFET taught in US—A—4,080,618 includes a tip implant structure which allows the channel beneath the gate to be short while simultaneously allowing the deep diffusion portions to be moved apart from one another to help eliminate depletion region punch-through. It has been found, however, that this design approach will also find its limit as the channel is made shorter and the device is made smaller.

The known constructions described above have required a delicate balance between junction spacings and doping levels in order to prevent punch-through and to minimize junction capacitance. However, as device dimensions are continuously made smaller, the problems are exacerbated and balancing is not intirely successful.

This invention aims at providing a short channel field effect transistor designed to have an even-shorter channel between source and drain and which eliminates the need to balance the critical device parameters, as heretofore required, while achieving the desired results, and which is as claimed in the appended claims.

A more complete understanding of the present invention and its advantages may be obtained by reference to the following description taken in conjunction with the accompanying drawings in which:

Figure 1 is a side sectional view of a known conventional MOSFET.

Figure 2 is a view of the device or Figure 1 showing the inversion layer, the depletion region and the punch-through effect;

Figure 3 is a side sectional view of a known shallow diffusion MOSFET device;

Figure 4 is a side sectional view of a known tip implant MOSFET device;

Figure 5 is a side sectional view of the enhancement mode MOSFET device of the present invention;

Figure 6 is an enlarged sectional view of the plug diffusion of Figure 5;

Figure 7 is a side sectional view of the depletion mode MOSFET device of the present invention;

Figure 8 is a side sectional view of an alternative embodiment of the MOSFET device of the present invention wherein the active elements are disposed upon an insulating substrate.

The known devices shown in Figures 1 through 4 of the drawings have been generally described in the background portion of this disclosure. The novel device of the present invention will now be described with reference to Figures 5 through 7.

The embodiment of this invention as illustrated in Figure 5 represents an enhancement mode type of device which is normally "OFF". It comprises a bulk substrate 10 of p-type monocrystalline silicon having a low dopant concentration of approximately $10^{15} \text{cm}^{-3}$. Two $N^+$ type diffused junctions 12 and 14, disposed in the substrate 10, act as the source and drain, respectively. Each diffused junction 12 and 14 includes a deep diffusion region 16 and 18 extending to a depth of approximately 0.7 µm and a shallow diffusion region, or tip, 20 and 22 extending to a depth considerably less than 0.7 µm. The dopant concentration of each of these regions is selected to obtain the desired beneficial results and to minimize the deleterious results, as described above. Thus, deep diffused regions 16 and 18 are optimized to have high conductivity for interconnect and contacting and may be doped with an appropriate material, such as arsenic or phosphorus, to a surface doping density of approximately $10^{19} \text{cm}^{-3}$. Similarly, the shallow diffused regions 20 and 22 are optimized for extreme shallowness and may be doped with a suitable material, such as arsenic, to a surface doping density of approximately $10^{16} \text{cm}^{-3}$. A channel, having a length which may be as short as 0.5 µm, extends between the facing surfaces of tips 20 and 22. Two relatively heavily doped $P^+$ plugs or stoppers 24 and 26 are diffused beneath the tips 20 and 22. The plugs may be suitably doped with boron to a doping concentration of approximately $10^{17} \text{cm}^{-3}$. A thin dielectric layer 28, of silicon dioxide or other suitable insulating material, having a thickness of about 0.03 µm is provided on the surface of the substrate extending from the tip regions 20 and 22 of source 12 and drain 14. A conductive layer 30 of suitable interconnect material, such as heavily doped polysilicon or aluminum, is provided over the dielectric layer 28, to a thickness of about 5 µm. Ohmic contacts represented by leads 32 and 34 to the source 12 and drain 14, respectively, overlie the deep diffusion zones 16 and 18.

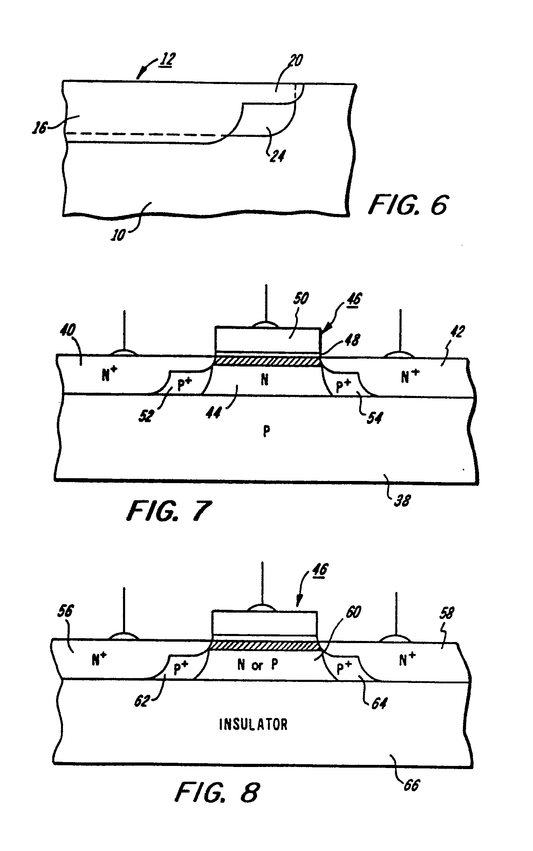

The method taught by US—A—4,198,250 or a similar method may be utilized advantageously to form the source and drain, as illustrated herein, including a deep diffusion portion and a shallow diffusion portion. The plugs 20 and 22 may then be formed by an implant doping of the suitably selected dopant in a region substantially coextensive with the source and drain, as illustrated in Figure 6. It is important that the net effect of the plug implant doping causes the deep junction 16 and tip 20 to remain $N^+$, while the plug is made $P^+$. Two factors are important in positioning the plugs during device fabrication. First, the facing portions of the tips 20 and 22 must remain unblocked in order to allow the inversion layer 36 to be formed directly below the gate 30 and second, the depth of diffusion of the plugs must be slightly shallower than the deep diffusion regions 16 and 18. If the plug diffusions were made deeper than the source and drain deep diffusion regions, the overall device junction capacitance at the interface between these N⁺ doped regions 16 and 18 and the heavily doped P⁺ plugs would increase to an unacceptable level.

In operation, this novel device allows for shorter channel lengths than have heretofore been reliably achievable in this type of logic device. The improved configuration independently combats the problem of punch-through without substantially increasing the overall device junction capacitance, as has been the case with selectively doped known devices.

If desired, the tips may be more heavily doped to further fight punch-through. Of course, as has been described, such doping will have the effect of raising the junction capacitance at the tip-plug interface. However, as the tips represent such a small portion of the overall device area, notwithstanding that the junction capacitance will be high in this limited region, its effect on the operation of the device will be negligible. Simultaneously, the deep diffusion areas 16 and 18 may interface with the lightly doped substrate, thus substantially decreasing the junction capacitance in this major area portion of the device. Although this arrangement will enhance the growth of depletion regions, the plugs will act as a shield against the growth of the depletion regions from those portions of the deep diffusion areas facing one another. Thus, as will be observed, in Figure 5, the depletion region (represented by the phantom lines) will be confined to grow only below the deep diffusion areas, where it will have no effect on punch-through.

Another embodiment of the invention is shown in Figure 7. This represents a depletion mode type of device which is normally "ON", i.e., current normally flows between the source and drain when the gate voltage is below threshold. The application of sufficient gate voltage, of the proper polarity, will pinch off current flow. The device comprises a p-type substrate 38 in which N⁺ source and drain diffusions 40 and 42, respectively, each including shallow and deep areas, are formed. An n-type doped channel region 44 spans the region between source and drain underlying a gate 46, comprised of an oxide layer or other insulating layer 48 and a conductive layer 50 overlying the substrate 36. Heavily doped P⁺ plugs 52 and 54, similar to those disclosed in the embodiment of Figures 5 and 6, underlie the shallow diffusion areas of source and drain and extend down to the substrate 38.

In operation, when the gate 46 carries a switching potential, an inversion layer 56 is formed as the n-type area 44 thereunder is converted to p-type and conduction is shut off. In the absence of the plugs 46 and 48, pinch-off current control is inherently slow and generally requires higher gate voltages. The reason therefor is readily apparent; a large volume of semiconductor material is required to be converted (the entire area 44). The present invention, in this mode, will dramatically increase the speed of operation of this device for two reasons. First, it is necessary to deplete or convert only a very shallow region under the gate to pinch off current flow and second, the short channel between source and drain may be further diminished because the plugs will eliminate the depletion region and subsequent punch-through which would be formed after pinch-off in the known devices of this type.

Yet another embodiment of the present invention is illustrated in Figure 8. It differs from the previously described embodiments of this invention in that the source 56, the drain 58, the channel region 60 and the plugs 62 and 64 are disposed upon an insulator 66. This device may be either of the enhancement mode or depletion mode, depending on whether a p-type or n-type dopant is used in the channel region 60. It should be apparent that this structure is fully optimized to prevent punch-through and to eliminate junction capacitance beneath the deep diffusion portion of the source and drain.

## Claims

1. A short channel field effect transistor including:

a substrate (10);

a source region (12) of one conductivity type disposed in a first surface portion of the substrate and comprising a relatively-shallow diffused tip portion (20) laterally offset from, and contiguous with, a relatively-deep diffused portion, (16);

a drain region (14) of the same conductivity type in a second surface portion of the substrate and comprising a relatively-shallow diffused tip portion (22) laterally offset from, and contiguous with, a relatively-deep diffused portion (18), wherein the drain tip portion faces the source tip portion;

a channel region (36), of either conductivity type, disposed in a third surface portion of the substrate between the source and drain regions;

a gate insulation film (28) located on a surface of the substrate between the source and drain regions and overlying the channel region;

a gate electrode (30) located upon the gate insulation film;

a source contact (32) upon the upper surface of the source region;

a drain contact (34) upon the upper surface of the drain region, characterised by

plug regions (24, 26) of the other conductivity type and each associated with, and contiguous with, each source and drain region, each plug region being located beneath a tip portion and between the deep diffused portions and the channel region, the plug regions being separated by the channel region by a distance not less than the shortest distance between the source and drain tip portions, and by the plug regions being no deeper than the greatest depth of the source and drain deep-diffused portions.

2. A field effect transistor as claimed in claim 1, in which the substrate is of a semiconductive material (10, 38) of the conductivity type opposite to that of the source and drain regions.

3. A transistor as claimed in claim 1, in which the source and drain electrodes overlie the deep diffused portions.

4. A transistor as claimed in any preceding claim, in which the channel region (44) is of the said one conductivity type.

5. A transistor as claimed in 4 as dependent from claim 2, in which the channel region has an impurity concentration approximately the same as that of the substrate.

6. A transistor as claimed in claim 1, in which the substrate is of an insulation material (66).

7. A transistor as claimed in claim 6, including a channel region (60) of semiconductive material of either conductivity type located below the gate electrode and contiguous with the plug regions and the unshielded end faces of the tip portions of the source and drain regions.

## Revendications

1. Transistor à effet de champ à canal court, comprenant:
— un substrat (10);
— une région de source (12) d'un type de conductibilité disposée dans une première partie de surface du substrat et comportant une partie de sommet (20) à déplacement relativement peu profond, décalée latéralement, en étant contiguë, d'une partie (16) à déplacement relativement profond;
— une région de drain (14) du même type de conductibilité dans une seconde partie de surface du substrat et comprenant une partie de sommet (22) à déplacement relativement peu profond, décalée latéralement, en étant contiguë, d'une partie (18) à déplacement relativement profond, où la partie de sommet du drain est en regard de la partie de sommet de la source;
— une région de canal (36), de l'un ou l'autre type de conductibilité disposée dans une troisième partie de surface du substrat entre les régions de source et de drain;
— une pellicule isolante de grille (28), située sur une surface du substrat entre les régions de source et de drain et recouvrant la région de canal;
— une électrode de grille (30) située sur la pellicule isolante de grille;
— un contact de source (32) sur la surface supérieure de la région de source;
— un contact de drain (34) sur la surface supérieure de la région de drain; caractérisé par:
— des régions de bouchon (24, 26) de l'autre type de conductibilité et associées chacune, en étant contiguë, à chaque région de source et de drain, chaque région de bouchon étant située au-dessous d'une partie de sommet et entre les parties à déplacement profond et la région de canal, les régions de bouchon étant séparées par la région de canal par une distance non inférieure à la distance la plus courte entre les parties de sommet de la source et du drain, et par les régions de bouchon qui ne sont pas plus profondes que la profondeur la plus grande des parties à déplacement profond de la source et du drain.

2. Transistor à effet de champ selon la revendication 1, dans lequel le substrat est en matériau semi-conducteur (10, 38) du type de conductibilité opposé à celui des régions de source et de drain.

3. Transistor selon la revendication 1, dans lequel les électrodes de source et de drain recouvrent les parties à déplacement profond.

4. Transistor selon l'une quelconque des revendications précédentes, dans lequel la région de canal (44) est du premier type de conductibilité.

5. Transistor selon la revendication 4, dépendant de la revendication 2, dans lequel la région de canal a une concentration en impureté approximativement identique à celle du substrat.

6. Transistor selon la revendication 1, dans lequel le substrat est en matériau isolant (66).

7. Transistor selon la revendication 6, comprenant une région de canal (60) en matériau semi-conducteur de l'un ou l'autre type de conductibilité, qui est située au-dessous de l'électrode de grille et contiguë aux régions de sommet et les faces d'extrémité non protégées des parties de sommet des régions de source et de drain.

## Patentansprüche

1. Feldeffekttransistor mit kurzem Kanal mit:
einem Substrat (10),
ein Source-Bereich (12) einer Leitfähigkeitsart, der in einem ersten oberflächenabschnitt des Substrats angeordnet ist und einem relativ flach diffundierten Spitzenabschnitt (20), der seitlich von einem relativ tief diffundierten Abschnitt (16) abgesetzt ist und an diesen angrenzt, aufweist,
einem Drain-Bereich (14) der gleichen Leitfähigkeitsart in einem zweiten Oberflächenabschnitt des Substrats, der einen relativ flach diffundierten, Spitzenabschnitt (22) aufweist, der seitlich von einem relativ tief diffundierten Abschnitt (18) abgesetzt ist und an diesen angrenzt, wobei der Drain-Spitzenabschnitt zu den Source-Spitzenabschnitt weist,
einem Kanalbereich (36) mit einer der beiden Leitfähigkeitsarten, der in einem dritten Oberflächenabschnitt des Substrats zwischen dem Source- und Drain-Bereich angeordnet ist,
einer Gate-Isolierschicht (28), die auf einer Oberfläche des Substrats zwischen dem Source- und Drain-Bereich angeordnet ist und über dem Kanalbereich liegt,
einer Gate-Elektrode (30), die sich auf der Gate-Isolierschicht befindet,
einem Source-Kontakt (32) auf der oberen Oberfläche des Source-Bereiches,
einem Drain-Kontakt (34) auf der oberen Oberfläche des Drain-Bereiches,
gekennzeichnet, durch größere Bereiche (24, 26) mit der anderen Leitfähigkeitsart, die jeweils dem Source-Bereich und dem Drain-Bereich zugeordnet sind und jeweils angrenzen, wobei sich jeder größere Bereich unter einem Spitzenabschnitt und zwischen den tief diffundierten Abschnitten und dem Kanalbereich befindet und die größeren Bereiche durch den Kanalbereich durch einen Abstand getrennt sind, der nicht kleiner als der kürzeste Abstand zwischen den Source- und Drain-Spitzenabschnitten ist, und wobei die größeren Bereiche nicht tiefer als die größte Tiefe der tief diffundierten Source- und Drain-Abschnitte ist.

2. Feldeffekttransistor nach Anspruch 1, bei dem das Substrat aus einem Halbleitermaterial (10, 38) von einer Leitfähigkeitsart besteht, die zu derjenigen des Source- und Drain-Bereiches entgegengesetzt ist.

3. Transistor nach Anspruch 1, bei dem die Source- und Drain-Elektrode über den tief diffundierten Abschnitten liegt.

4. Transistor nach einem der vorhergehenden Ansprüche, bei dem der Kanalbereich (44) von der einen Leitfähigkeitsart ist.

5. Transistor nach Anspruch 4, wenn dieser von Anspruch 2 abhängt, bei dem der Kanalbereich eine Störstellenkonzentration aufweist, die ungefähr die gleiche des Substrats ist.

6. Transistor nach Anspruch 1, bei dem das Substrat aus einem isolierenden Material (66) besteht.

7. Transistor nach Anspruch 6, mit einem Kanalbereich (60) aus Halbleitermaterial von einer der Leitfähigkeitsarten, der unterhalb der Gate-Elektrode angeordnet ist und an die größeren Bereiche und die nicht abgeschirmten Endseiten der Spitzenabschnitte des Source- und Drain-Bereiches angrenzt.

$V_G$

CONDUCTOR

GATE

OXIDE

SOURCE N

N DRAIN

SUBSTRATE P

**FIG. 1** *(PRIOR ART)*

$V_G$

INVERSION
LAYER $V_G > V_T$

DEPLETION
REGION

**FIG. 2** *(PRIOR ART)*

SHORT CIRCUIT

DEPLETION
REGION

**FIG. 3** *(PRIOR ART)*

FIG. 4 (PRIOR ART)

FIG. 5

_12_

_16_

_20_

_24_

_10_

*FIG. 6*

_50_     _46_

_40_          _48_     _42_

N⁺     P⁺     N     P⁺     N⁺

_52_     _44_     _54_

P

_38_

*FIG. 7*

_46_

_56_     _60_     _58_

N⁺     P⁺     N or P     P⁺     N⁺

_62_     _64_

INSULATOR

_66_

*FIG. 8*